# EUROPÄISCHE PATENTSCHRIFT

(11) **EP 3 624 341 B1**
(45) Veröffentlichungstag und Bekanntmachung des Hinweises auf die Patenterteilung: **01.06.2022**
(21) Anmeldenummer: 19194889.2
(22) Anmeldetag: 02.09.2019
(51) Int. Cl.: H03K 17/785, H03K 17/74, H03K 17/06

(54) **PULSGEBER**
PULSE GENERATOR
ÉMETTEUR D'IMPULSIONS

(30) Priorität: 14.09.2018 DE 102018007284
(43) Veröffentlichungstag der Anmeldung: 18.03.2020
(73) Patentinhaber: Diehl Metering GmbH, 91522 Ansbach (DE)
(72) Erfinder: Nickl, Stefan, 90547 Stein (DE)
(74) Vertreter: Diehl Patentabteilung

(56) Entgegenhaltungen:
- WO-A1-97/22382
- WO-A1-2015/068194
- JP-A- H04 332 217
- US-A1- 2007 084 987

## Beschreibung

Die Erfindung betrifft einen Pulsgeber mit galvanisch getrenntem Ausgang, insbesondere für einen Verbrauchszähler, wobei ein Steuerausgang einer Steuereinrichtung des Pulsgebers mit einem Eingang eines Optokopplers des Pulsgebers gekoppelt ist, um am Ausgang des Optokopplers einen durch die Steuereinrichtung gesteuerten Ausgangsstrom auszugeben.

Eine einfache Möglichkeit, Informationen von einer Vorrichtung an eine weitere Vorrichtung bereitzustellen, ist ein Pulsgeber, der beispielsweise durch eine Schaltung von Impedanzen oder Potentialen eine Pulsleitung zwischen zwei definierten Zuständen schaltet. Solche Pulsgeber werden beispielsweise in Verbrauchszählern, also beispielsweise in Wasserzählern, Gaszählern, Wärmezählern und Ähnlichem, genutzt, um Messdaten oder eine aus diesen ermittelte Größe, beispielsweise einen integrierten Fluiddurchfluss als Verbrauch, an externe Einrichtungen bereitzustellen. Dies ermöglicht es beispielsweise einem Endverbraucher, die durch einen Zähler bereitgestellten Daten weiterzuverarbeiten.

Ein steilflankiges Schalten und/oder durch die externe Einrichtung eingebrachte Störungen können, wenn der Pulsgeber galvanisch mit einer weiteren Schaltung, beispielsweise einer Messschaltung, gekoppelt ist, diese stören. Es ist daher zweckmäßig, den Ausgang des Pulsgebers von weiteren Einrichtungen, beispielsweise einer Messeinrichtung des Verbrauchszählers, zu entkoppeln. Hierzu kann beispielsweise ein Optokoppler genutzt werden. Optokoppler umfassen eingangsseitig eine durch das Steuersignal gesteuerte Lichtquelle, beispielsweise eine Leuchtdiode. Ausgangsseitig wird entweder eine Impedanz geschaltet, beispielsweise über einen Fotowiderstand oder einen Foto-Feldeffekttransistor, oder es wird ein über die Lichteinstrahlung vorgebbarer Ausgangsstrom ausgegeben, beispielsweise indem ausgangsseitig wenigstens eine Fotodiode genutzt wird.

Soll ein solcher Optokoppler über längere Zeiträume bzw. mit großen Pulsbreiten in einem Zustand betrieben werden, in dem eine interne Lichtquelle aktiv ist, resultiert ein relativ großer Energieverbrauch. Dies kann insbesondere problematisch sein, wenn der Pulsgeber in einer batteriebetriebenen Einrichtung, beispielsweise einem batteriebetriebenen Verbrauchszähler, genutzt wird. Um dies zu vermeiden, können flankengesteuerte Optokoppler genutzt werden, die eine eigene Speicherlogik umfassen, um einen einmal eingestellten Schaltzustand über längere Zeiträume aufrechtzuerhalten. Eine entsprechende Speicherlogik benötigt jedoch eine zusätzliche Spannungsversorgung, um die galvanische Trennung aufrechtzuerhalten. Hierdurch erhöhen sich die Herstellungskosten des Pulsgebers bzw. eines Verbrauchszählers, der diesen umfasst. Die Druckschriften WO 97/22382 A1, JP H04 332217 A, US 2007/084987 A1 und WO 2015/068194 A1 offenbaren Schaltungen nach dem Stand der Technik, die Optokoppler aufweisen.

Der Erfindung liegt somit die Aufgabe zugrunde, einen Pulsgeber anzugeben, der trotz eines relativ einfachen und günstigen Aufbaus eine hohe Energieeffizienz auch bei großen Pulsbreiten erreichen kann.

Die Aufgabe wird erfindungsgemäß durch einen Pulsgeber der eingangs genannten Art gelöst, wobei der Optokoppler derart mit einem Feldeffekttransistor verschaltet ist, dass der Ausgangsstrom des Optokopplers eine Kapazität über ein gleichrichtendes Bauelement, beispielsweise eine Diode, lädt, das ein Entladen der Kapazität über den Optokoppler sperrt, wobei die an der Kapazität abfallende Spannung die Gatterspannung des Feldeffekttransistors ist, wobei der Feldeffekttransistor den Ausgang des Pulsgebers direkt oder indirekt schaltet.

Bei dem erfindungsgemäßen Pulsgeber wird ein Optokoppler genutzt, der in Abhängigkeit eines Eingangssignals einen Ausgangsstrom bereitstellt. Ein solcher Optokoppler kann beispielsweise durch Nutzung einer eingangsseitigen Leuchtdiode und einer ausgangsseitigen Fotodiode oder mehrerer ausgangsseitiger Fotodioden bereitgestellt werden. Der Ausgangsstrom folgt im Wesentlichen dem Eingangssignal. Die Kapazität integriert den Ausgangsstrom, womit die an der Kapazität abfallende Spannung steigt, solange beispielsweise auf die ausgangsseitige Fotodiode Licht eingestrahlt wird. Sobald die an der Kapazität abfallende Spannung ausreichend groß ist, schaltet der Feldeffekttransistor und somit der Ausgang des Pulsgebers. Der Feldeffekttransistor kann den Pulsausgang direkt oder indirekt über weitere Komponenten, z.B. einen weiteren Transistor, einen Verstärker oder Ähnliches, schalten.

Wäre die Kapazität ohne das dazwischen geschaltete gleichrichtende Bauelement mit dem Optokoppler gekoppelt, so würde die Kapazität, wenn kein weiteres Licht mehr auf die ausgangsseitige Fotodiode eingestrahlt wird, über diese entladen, womit wiederum der Feldeffekttransistor und somit der Ausgang geschaltet würden. Ein Ausgangssignal des Pulsgebers würde somit im Wesentlichen einem geringfügig verzögerten Signal am Steuergang entsprechen.

Durch die Nutzung des zwischen den Optokoppler und die Kapazität geschalteten gleichrichtenden Bauelements wird dieses Entladen verhindert, so dass die Kapazität zunächst auch dann weiter geladen bleibt, wenn kein Licht mehr auf die ausgangsseitige Fotodiode des Optokopplers eingestrahlt wird. Vorzugsweise erfolgt in zumindest einem Zustand des Pulsgebers eine sehr langsame Entladung der Kapazität, beispielsweise ausschließlich über Kriechströme. Wie später noch genauer erläutert werden wird, kann die Kapazität bei Bedarf gezielt entladen werden, um den Ausgang des Pulsgebers zurückzuschalten. Alternativ könnte beispielsweise ein relativ großer Widerstand parallel zur Kapazität geschaltet werden, so dass sich die Kapazität über ein definiertes Zeitintervall entlädt. Hierdurch kann beispielsweise ein Pulsgeber implementiert werden, bei dem ein Schaltzustand des Feldeffekttransistors bzw. am Ausgang des Pulsgebers beispielsweise um eine vorgegebene Zeit länger aufrechterhalten wird, als ein Puls am Steuerausgang der Steuereinrichtung, der dieses Schalten auslöst.

Der Pulsausgang des Pulsgebers kann zwischen zwei definierten Spannungsniveaus umgeschaltet werden. Ein besonders niedriger Energieverbrauch des Pulsgebers bzw. einer den Pulsgeber umfassenden Einrichtung kann jedoch erreicht werden, wenn der Pulsausgang zwei Anschlüsse aufweist und eine zwischen diesen Anschlüssen angeordnete Impedanz geschaltet wird. Beispielsweise kann zwischen einer im Wesentlichen offenen Verbindung zwischen den beiden Anschlüssen und einem definierten Widerstand umgeschaltet werden.

Die Pole der Kapazität können mit ausgangsseitigen Anschlüssen eines weiteren Optokopplers des Pulsgebers verbunden sein, wobei ein Eingang des weiteren Optokopplers mit einem weiteren Steuerausgang der Steuereinrichtung gekoppelt ist. Der weitere Optokoppler kann ausgangsseitig insbesondere in Abhängigkeit der Ansteuerung durch die Steuereinrichtung einen Widerstand zwischen den Polen der Kapazität vorgeben. Vorzugsweise wird als weiterer Optokoppler ein Optokoppler genutzt, der ausgangsseitig einen Fototransistor, insbesondere einen Foto-Feldeffekttransistor aufweist. Alternativ könnte beispielsweise ein Optokoppler mit ausgangsseitigem Fotowiderstand oder ein Optokoppler mit invertiertem Ausgang genutzt werden. Durch Ansteuerung des weiteren Optokopplers kann die Kapazität gezielt entladen werden, womit eine an dieser Kapazität abfallende Spannung reduziert wird, womit der Feldeffekttransistor und somit der Ausgang des Pulsgebers in einen Ausgangszustand zurückgeschaltet werden können.

Der Pulsgeber kann dazu eingerichtet sein, einen Schaltzustand des Ausgangs des Pulsgebers für ein vorgegebenes Zeitintervall vorzugeben, wobei die Steuereinrichtung am Ende des vorgegebenen Zeitintervalls an dem weiteren Steuereingang einen Steuerpuls ausgibt. Das Schalten in den Schaltzustand am Ausgang des Pulsgebers erfolgt, wie später noch genauer erläutert wird, durch eine Ausgabe mehrerer Schaltpulse an dem Steuerausgang der Steuereinrichtung. Wie eingangs erläutert, kann dies zu einem längerfristigen Halten dieses Schaltzustands führen. Durch die Ausgabe eines Steuerpulses an den weiteren Optokoppler kann die Kapazität gezielt entladen werden und somit der Ausgang des Pulsgebers zurückgeschaltet werden.

Der Pulsgeber ist dazu eingerichtet, den oder einen Schaltzustand des Ausgangs des Pulsgebers für das vorgegebene oder ein vorgegebenes Zeitintervall vorzugeben, indem die Steuereinrichtung während des vorgegebenen Zeitintervalls an dem Steuerausgang mehrere Pulse ausgibt. Durch die Ausgabe eines Pulses an dem Steuerausgang wird die Ausgabe eines Strompulses durch den Optokoppler ausgelöst. Dies führt dazu, dass die Kapazität mit einer Strommenge geladen wird, die insbesondere von der Länge des Pulses am Steuerausgang abhängt. Die Pulslänge kann nun so gewählt werden bzw. es können so viele Pulse ausgegeben werden, dass die an der Kapazität abfallende Spannung ausreicht, um den Feldeffekttransistor und somit den Ausgang des Pulsgebers zu schalten. Da typischerweise eine geringfügige Entladung der Kapazität, beispielsweise über einen großen Entladewiderstand oder über Leckströme, erfolgt, können während des Zeitintervalls zudem weitere Pulse am Steuerausgang ausgegeben werden, um durch weitere Strompulse am Ausgang des Optokopplers die auf der Kapazität gespeicherte Ladung ausreichende hoch zu halten, dass die an der Kapazität abfallende Spannung ausreicht, um den Schaltzustand des Feldeffekttransistors aufrechtzuerhalten. Hierdurch wird ermöglicht, dass ein Schaltzustand des Feldeffekttransistors durch Ausgabe zeitlich beabstandeter Steuerpulse am Steuerausgang aufrechterhalten werden kann. Sollte der Ausgang des Pulsgebers hingegen direkt durch den Optokoppler geschaltet werden, wäre eine dauerhafte Bestromung des Optokopplers durch die Steuereinrichtung erforderlich. Eine Bestromung des Optokopplers durch die Steuereinrichtung über den Steuerausgang mit zeitlich beabstandeten Pulsen erfordert demgegenüber eine erheblich geringere Energie, so dass der Pulsgeber besonders stromsparend realisiert werden kann.

Die Steuereinrichtung ist dazu ausgebildet, zu Beginn des vorgegebenen Zeitintervalls an dem Steuerausgang einen ersten Puls mit einer ersten Länge und anschließend während des Zeitintervalls wenigstens einen zweiten Puls mit einer zweiten Länge, die kürzer als die erste Länge ist, auszugeben. Der erste Puls dient, wie obig erläutert, dazu, die Kapazität so weit zu laden, dass der Feldeffekttransistor schaltet. Die folgenden Pulse müssen ausschließlich die Entladung über Kriechströme bzw. über einen typischerweise großgewählten Entladewiderstand kompensieren und können somit erheblich kürzer sein. Der erste Puls kann einige 10 µs, beispielsweise 24 µs, lang sein. Die Folgepulse können einige µs, beispielsweise 4 µs, lang sein. Jeder der Pulse kann ausreichen, die Kapazität ausreichend stark zu laden, um den Schaltzustand des Feldeffekttransistors für einige 100 µs, vorzugsweise einige ms, aufrechtzuerhalten. Beispielsweise kann hierdurch ermöglicht werden, dass nach dem ersten Puls für 2 ms keine weiteren Pulse folgen und/oder dass die Pulse zur Ladungsaufrechterhaltung im Abstand von 1 ms ausgegeben werden und trotz dieser relativ großen Pulsabstände ein Schaltzustand des Feldeffekttransistors aufrechterhalten wird.

Der erste Puls kann wenigstens um den Faktor zwei oder wenigstens um den Faktor fünf länger sein als der zweite Puls oder die zweiten Pulse und/oder der Abstand zwischen aufeinanderfolgenden Pulsen kann wenigstens zehnmal oder wenigstens dreißigmal so groß sein wie die Pulslänge. Wie vorangehend erläutert können sogar noch größere Unterschiede der Pulslängen bzw. noch größere Abstände der Pulse genutzt werden.

Die Kapazität kann ausschließlich oder zumindest teilweise durch eine Gatterkapazität des Feldeffekttransistors gebildet werden. Es ist prinzipiell möglich, dass als Kapazität ausschließlich eine durch den Feldeffekttransistor selbst bereitgestellte Kapazität geladen wird. Beispielsweise kann eine zwischen Gatteranschluss und Quellanschuss des Feldeffekttransistors vorhandene Kapazität geladen werden. Um jedoch trotz vorhandener Kriechströme eine längere Aufrechterhaltung eines Schaltzustandes des Feldeffekttransistors bzw. des Ausgangs des Pulsgebers zu ermöglichen, sollte vorzugsweise eine größere Kapazität genutzt werden, die durch Nutzung einer zusätzlichen Kapazität, insbesondere eines zusätzlichen Kondensators, realisiert werden kann.

Insbesondere kann die Kapazität zumindest teilweise durch eine Kapazität, insbesondere einen Kondensator, gebildet werden, die zwischen zwei Anschlüsse des Feldeffekttransistors geschaltet ist. Die zusätzliche Kapazität kann somit parallel zu der Gatterkapazität des Feldeffekttransistors geschaltet sein. Hierdurch kann der Einfluss der Gatterkapazität auf das Schaltverhalten des Pulsausgangs reduziert werden. Die Kapazität des Kondensators kann beispielsweise fünfmal bis zwanzigmal so groß, beispielsweise ungefähr zehnmal so groß, sein wie die Gatterkapazität. Insbesondere kann die Kapazität zwischen einen Gatter- und einen Quellanschluss des Feldeffekttransistors geschaltet werden. Durch die Parallelschaltung des Kondensators zu der Kapazität des Feldeffekttransistors resultiert eine erhöhte Gesamtkapazität. Dies führt dazu, dass durch die Kapazität bei gleicher an der Kapazität abfallender Spannung mehr Ladung gespeichert ist, wodurch es bei einem gleichen Kriechstrom bzw. gleichem Entladewiderstand länger dauert, bis die an der Kapazität abfallende Spannung sinkt und somit der Feldeffekttransistor bzw. der Ausgang des Pulsgebers zurückschaltet. Wird beispielsweise von einem Entladewiderstand für Kriechströme von 12 MΩ ausgegangen, können Kapazitäten von einigen 10 pF, beispielsweise von 27 pF, ausreichend sein, um die obig genannten Pulsabstände bei den genannten Pulslängen zu erreichen.

Als Feldeffekttransistor kann beispielsweise ein Metall-Oxid-Halbleiter-Feldeffekttransistor verwendet werden.

Neben dem erfindungsgemäßen Pulsgeber betrifft die Erfindung einen Verbrauchszähler zur Erfassung eines Energieverbrauchs und/oder des Verbrauchs bzw. des Durchflusses eines Fluids, der einen erfindungsgemäßen Pulsgeber umfasst, insbesondere um Messdaten oder aus diesen abgeleitete Daten an eine separate Einrichtung bereitzustellen. Der Pulsgeber kann insbesondere in eine Steuer- bzw. Verarbeitungseinrichtung des Verbrauchszählers integriert werden.

Weitere Vorteile und Einzelheiten der Erfindung ergeben sich aus den folgenden Ausführungsbeispielen sowie den zugehörigen Zeichnungen. Hierbei zeigen schematisch:
- Fig. 1: ein Ausführungsbeispiel eines erfindungsgemäßen Verbrauchszählers,
- Fig. 2: eine Detailansicht des in Fig. 1 gezeigten Verbrauchszählers, die ein Ausführungsbeispiel eines erfindungsgemäßen Pulsgebers zeigt, und
- Fig. 3: ein Ausgangssignal des in Fig. 2 dargestellten Pulsgebers und die zur Bereitstellung dieses Ausgangssignals durch eine Steuereinrichtung ausgegebenen Steuersignale.

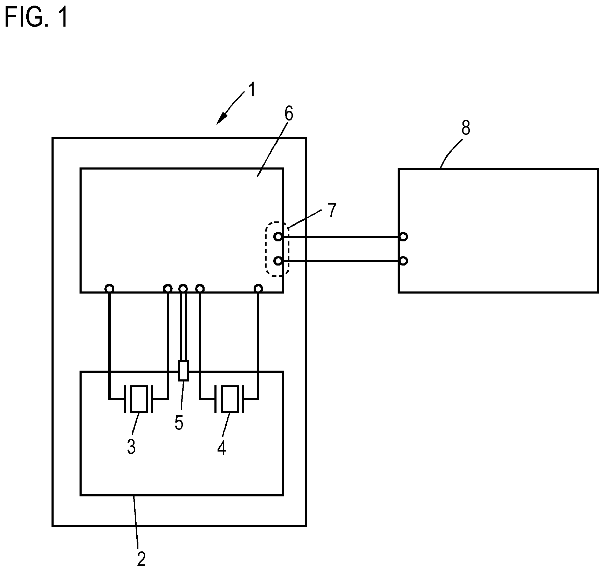

Fig. 1 zeigt einen Verbrauchszähler 1, der im Beispiel ein Ultraschallzähler zur Messung einer Durchflussmenge eines Fluids ist. Der Verbrauchszähler 1 umfasst einen Grundzähler 2, also die unmittelbar am Messrohr angeordnete Sensorik, und ein Rechenwerk 6, das die Sensorik steuert und deren Messwerte verarbeitet. Die Sensorik umfasst zwei Ultraschallwandler 3, 4 sowie einen Temperatursensor 5. Durch die Ultraschallwandler 3, 4 können Ultraschallwellen in ein Fluid, das durch ein nicht gezeigtes Messrohr fließt, eingestrahlt und aus diesem empfangen werden. Durch Messung einer Laufzeitdifferenz zwischen den Laufzeiten vom Ultraschallwandler 3 zum Ultraschallwandler 4 und umgekehrt kann eine Flussgeschwindigkeit ermittelt werden. Dieses Vorgehen ist im Stand der Technik wohl bekannt und soll nicht detailliert erläutert werden.

Der Zähler 1 weist typischerweise nur eingeschränkte Mittel zur Sichtung und Verarbeitung der Messdaten auf. Beispielsweise kann an dem Verbrauchszähler 1 ein nicht gezeigtes Display vorgesehen sein, um zyklisch bestimmte Messgrößen darzustellen oder Ähnliches. Um eine weitere Verarbeitung oder längerfristige Speicherung der Messdaten zu ermöglichen, können diese über einen Pulsgeber 7 an eine externe Einrichtung 8 bereitgestellt werden. Die externe Einrichtung 8 kann beispielsweise dazu dienen, Messwerte des Verbrauchszählers durch einen Ableser auszulesen oder als separate Einrichtung 8 kann eine Einrichtung eines Endbenutzers genutzt werden, die einem Endbenutzer beispielsweise eine detaillierte Aufschlüsselung eines zeitabhängigen Verbrauchs oder Ähnliches bereitstellen kann.

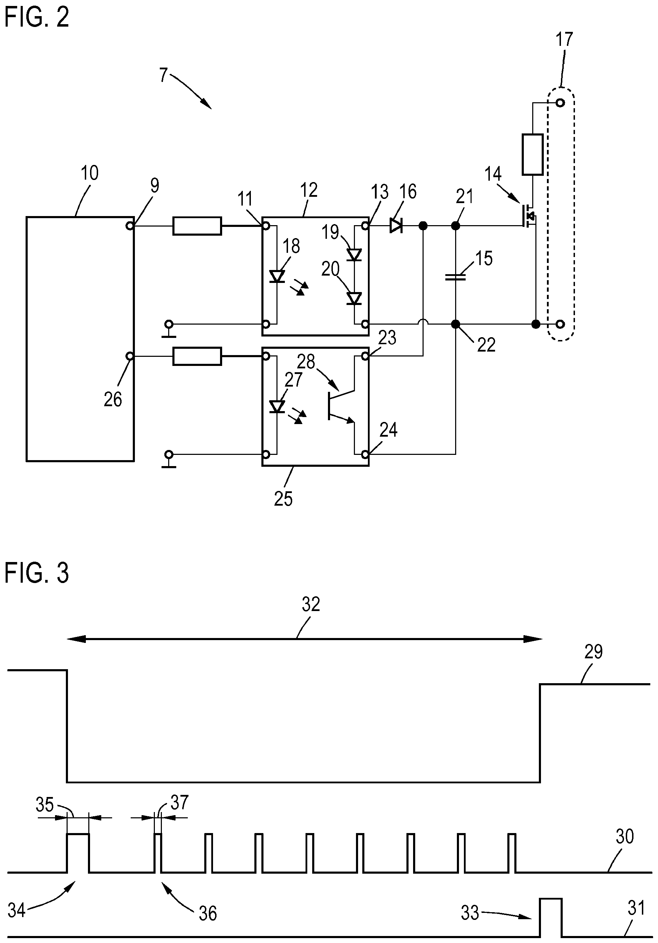

Der Pulsgeber 7 ist in Fig. 2 detailliert dargestellt. Der Ausgang 17 des Pulsgebers 7 ist vom weiteren Schaltkreis des Rechenwerks und insbesondere von der Sensorik im Grundzähler 2 galvanisch getrennt, um eine Einbringung von Störungen von der separaten Einrichtung 8 aus zu vermeiden. Diese galvanische Trennung erfolgt in dem Pulsgeber 7 über die beiden Optokoppler 12, 25.

Die beiden Anschlusspunkte des Ausgangs 17 werden zur Ausgabe von Pulsen am Ausgang 17 über den Feldeffekttransistor 14 wahlweise miteinander verbunden bzw. getrennt. Der Ausgangszustand des Pulsgebers kann über die separate Einrichtung 8 beispielsweise dadurch erfasst werden, dass ein Spannungsabfall an dem Ausgang 17 des Pulsgebers 7 gemessen wird. Durch eine geringfügige Modifikation des Pulsgebers 7, nämlich durch eine Kopplung eines der Anschlusspunkte mit einer Stromquelle bzw. über einen Widerstand mit einer Spannungsquelle und des anderen der Anschlusspunkt mit einem separaten Erdpotential kann beispielsweise auch ein Umschalter zwischen definierten Spannungen am Ausgang 17 realisiert werden.

Eine galvanische Trennung könnte prinzipiell dadurch realisiert werden, dass der Feldeffekttransistor 14 ein Foto- Feldeffekttransistor eines Optokopplers ist, der durch die Steuereinrichtung 10 angesteuert wird. Hierzu müsste jedoch, wenn der Feldeffekttransistor 14 für längere Zeiten leitend geschaltet werden soll, während der gesamten Zeit ein Steuersignal durch die Steuereinrichtung 10 ausgegeben werden. Dies ist nachteilig, da durch die dauerhafte Bestromung eines solchen Optokopplers durch die Steuereinrichtung 10 ein relativ hoher Stromverbrauch resultiert. Dies kann, wie im Folgenden genauer diskutiert werden wird, durch die in Fig. 2 dargestellte Schaltung für den Pulsgeber 7 vermieden werden.

Hierbei wird ein Steuerausgang 9 der Steuereinrichtung 10, die beispielsweise durch eine Verarbeitungs- bzw. Steuereinrichtung des Rechenwerks 6 implementiert sein kann, mit einem Eingang eines Optokopplers 12 gekoppelt, womit durch den Optokoppler 12 ein durch die Steuereinrichtung 10 steuerbarer, insbesondere digital an- und ausschaltbarer, Ausgangsstrom an dem Ausgang 13 bereitgestellt werden kann. Der Optokoppler 12 ist derart mit dem Feldeffekttransistor 14 verschaltet, dass der Ausgangsstrom des Optokopplers 12 eine Kapazität 15 über ein gleichrichtendes Bauelement 16, beispielsweise eine Diode, lädt, das ein Entladen der Kapazität 15 über den Optokoppler 12 sperrt. Die an der Kapazität 15 abfallende Spannung ist die Gatterspannung des Feldeffekttransistors 14. Ist die an der Kapazität 15 abfallende Spannung sehr gering, kann der Feldeffekttransistor 14 einen sehr hohen, im Wesentlichen unendlichen, Widerstand aufweisen, womit die Anschlusspunkte des Ausgangs 17 getrennt sind. Wird die Kapazität 15 ausreichend hoch geladen, wird durch die an ihr abfallende Spannung der Feldeffekttransistor 14 geschaltet, womit dessen Widerstand sehr klein wird, womit die Anschlusspunkte des Ausgangs 17 des Pulsgebers 7 über einen definierten Widerstand verbunden werden.

Da die Kapazität 15 aufgrund des gleichrichtenden Bauelements 16 nicht über die Optokoppler 12 entladen werden kann und das Gatter des Feldeffekttransistors 14 gegenüber den anderen Anschlüssen isoliert ist, wird die Kapazität 15 nur durch Kriechströme oder einen nicht gezeigten, relativ groß gewählten, Entladewiderstand entladen. Wird somit an dem Steuerausgang 9 ein ausreichend langer Puls ausgegeben, um über die Ladung der Kapazität 15 durch den Ausgangsstrom des Optokopplers 12 den Feldeffekttransistor 14 zu schalten, wird dieser Schaltzustand über längere Zeit beibehalten, auch wenn der Puls am Steuerausgang 9 längst beendet ist, womit im Optokoppler 12 über die Leuchtdiode 18 kein Licht abgestrahlt wird und somit über die Fotodioden 19, 20 kein weiterer Ladestrom für die Kapazität 15 mehr bereitgestellt wird.

Aufgrund der Entladung der Kapazität 15 durch Leckströme kann es, wenn der Ausgang 17 des Pulsgebers 7 für sehr lange Zeiträume geschaltet werden soll, gewünscht sein, wiederholt kurze Pulse am Steuerausgang 9 auszugeben, um die durch Kriechströme verlorengegangene Ladung auszugleichen. Dies wird im Folgenden mit Bezug auf Fig. 3 weiter erläutert. Fig. 3 zeigt drei Signale 29, 30, 31, wobei das Signal 29 ein Spannungsabfall ist, der durch das externe Gerät 8 am Ausgang 17 des Pulsgebers gemessen werden kann. Die Signale 30 und 31 sind Steuersignale, die durch die Steuereinrichtung an dem Steuerausgang 9 und dem weiteren Steuerausgang 26 ausgegeben werden. Zunächst werden ausschließlich die Signale 29 und 30 diskutiert. An dem Ausgang 17 soll für das Zeitintervall 32 ein vorgegebener Schaltzustand eingestellt werden, bei dem der Feldeffekttransistor 14 und somit der Ausgang 17 eine niedrige Impedanz aufweist, womit wenig Spannung an dem Ausgang 17 abfällt. Um dies zu erreichen, muss eine ausreichende Gatterspannung am Feldeffekttransistor 14 anliegen, das heißt, durch die Kapazität 15 soll eine ausreichend große Ladung gespeichert sein. Um ein erstes Schalten des Feldeffekttransistors 14 zu erreichen, kann der Puls 34 ausgegeben werden, der eine definierte Länge 35 aufweist. Diese kann beispielsweise einige 10 µs sein. Die Länge 35 ist so gewählt, dass das Zeitintegral des durch den Optokoppler 12 ausgegebenen Ausgangsstroms über diese Zeit ausreicht, um die Kapazität 15 soweit zu laden, dass die an ihr abfallende Spannung den Feldeffekttransistor 14 schaltet.

Da sich die Kapazität 15 über die Zeit durch Kriechströme oder einen nicht gezeigten Entladewiderstand entlädt, ist es erforderlich, die Kapazität 15 gelegentlich nachzuladen, um sicherzustellen, dass die an ihr abfallende Spannung weiterhin ausreicht, um den Feldeffekttransistor 14 zu schalten. Hierzu wird, beispielsweise nach 2 ms, begonnen, über den Steuerausgang 9 weitere kurze Pulse 36 zur Ladungserhaltung auszugeben. Die Länge 37 in dieser Pulse 36 ist vorzugsweise kürzer als die Länge 35 des Pulses 34, da diese Pulse 36 ausschließlich dazu dienen, am Ausgang 13 des Optokopplers 12 ausreichend Ladestrom für die Kapazität 15 bereitzustellen, um Verluste auszugleichen. Der Puls 36 kann beispielsweise im Abstand von 1 ms wiederholt werden, um den Ladezustand der Kapazität 15 aufrechtzuerhalten. Es kann somit erreicht werden, dass ein Schaltzustand des Ausgangs 17 über ein relativ langes Zeitintervall 32 aufrechterhalten werden kann, wobei während dieses Zeitintervalls 32 nur relativ kurze Pulse 34, 36 durch die Steuereinrichtung 10 ausgegeben werden müssen, um den Schaltzustand aufrechtzuerhalten.

Wird ausschließlich der Optokoppler 12 genutzt, um den Feldeffekttransistor 14 zu steuern, so könnte der Zeitpunkt, zu dem der Feldeffekttransistor 14 am Ende des Zeitintervall 32 zurück in seinen Ausgangszustand schaltet, typischerweise nur mit relativ geringer Genauigkeit bestimmt werden. Daher ist in der in Fig. 2 gezeigten Schaltung ein zusätzlicher Steuerausgang 26 der Steuereinrichtung 10 vorgesehen, durch den ein weiterer Optokoppler 25 gesteuert wird, dessen ausgangsseitige Anschlüsse 23, 24 mit den Polen 21, 22 der Kapazität 15 verbunden sind. Eingangsseitig weist der Optokoppler 25 eine Leuchtdiode 27 auf. Ausgangsseitig ist eine beleuchtungsabhängige Impedanz, insbesondere ein Foto-Feldeffekttransistor 28, vorgesehen. Die Steuereinrichtung 10 ist dazu eingerichtet, am Ende des vorgegebenen Zeitintervalls 32 den in Fig. 3 dargestellten Steuerpuls 33 am Steuerausgang 26 auszugeben. Hierdurch wird die Leuchtdiode 27 aktiviert und der Foto- Feldeffekttransistor 28 schaltet durch, wodurch die Kapazität 15 kurzgeschlossen bzw. vorzugsweise über einen nicht gezeigten Entladewiderstand entladen wird, womit der Feldeffekttransistor 14 schaltet und somit auch der Ausgang 17 des Pulsgebers 7.

### Bezugszeichenliste

- 1: Verbrauchszähler
- 2: Grundzähler
- 3: Ultraschallwandler
- 4: Ultraschallwandler
- 5: Temperatursensor
- 6: Rechenwerk
- 7: Pulsgeber
- 8: Einrichtung
- 9: Steuerausgang
- 10: Steuereinrichtung
- 11: Eingang
- 12: Optokoppler
- 13: Ausgang
- 14: Feldeffekttransistor
- 15: Kapazität
- 16: gleichrichtendes Bauelement
- 17: Ausgang
- 18: Leuchtdiode
- 19: Fotodiode
- 20: Fotodiode
- 21: Pol
- 22: Pol
- 23: Anschluss
- 24: Anschuss
- 25: Optokoppler
- 26: Steuerausgang
- 27: Leuchtdiode
- 28: Foto-Feldeffekttransistor
- 29: Signal
- 30: Signal
- 31: Signal
- 32: Zeitintervall
- 33: Steuerpuls
- 34: Puls
- 35: Länge
- 36: Puls
- 37: Länge

## Patentansprüche

1. Pulsgeber mit galvanisch getrenntem Ausgang (17), insbesondere für einen Verbrauchszähler (1), wobei ein Steuerausgang (9) einer Steuereinrichtung (10) des Pulsgebers (7) mit einem Eingang (11) eines Optokopplers (12) des Pulsgebers (7) gekoppelt ist, um am Ausgang (13) des Optokopplers (12) einen durch die Steuereinrichtung (10) gesteuerten Ausgangsstrom auszugeben, wobei der Optokoppler (12) derart mit einem Feldeffekttransistor (14) verschaltet ist, dass der Ausgangsstrom des Optokopplers (12) eine Kapazität (15) über ein gleichrichtendes Bauelement (16) lädt, das ein Entladen der Kapazität (15) über den Optokoppler (12) sperrt, wobei die an der Kapazität (15) abfallende Spannung die Gatterspannung des Feldeffekttransistors (14) ist, wobei der Feldeffekttransistor (14) den Ausgang (17) des Pulsgebers (7) direkt oder indirekt schaltet, **dadurch gekennzeichnet, dass** der Pulsgeber dazu eingerichtet ist, einen Schaltzustand des Ausgangs (17) des Pulsgebers (7) für ein vorgegebenes Zeitintervall (32) vorzugeben, indem die Steuereinrichtung (10) während des vorgegebenen Zeitintervalls an dem Steuerausgang (9) mehrere Pulse (34, 36) ausgibt, wobei die Steuereinrichtung (10) dazu ausgebildet ist, zu Beginn des vorgegebenen Zeitintervalls (32) an dem Steuerausgang (9) einen ersten Puls (34) mit einer ersten Länge (35) und anschließend während des Zeitintervalls (32) wenigstens einen zweiten Puls (36) mit einer zweiten Länge (37), die kürzer als die erste Länge (35) ist, auszugeben.

2. Pulsgeber nach Anspruch 1, **dadurch gekennzeichnet, dass** die Pole (21, 22) der Kapazität (15) mit ausgangsseitigen Anschlüssen (23, 24) eines weiteren Optokoplers (25) des Pulsgebers (7) verbunden sind, wobei ein Eingang des weiteren Optokopplers (25) mit einem weiteren Steuerausgang (26) der Steuereinrichtung (10) gekoppelt ist.

3. Pulsgeber nach Anspruch 2, **dadurch gekennzeichnet, dass** er dazu eingerichtet ist, den Schaltzustand des Ausgangs (17) des Pulsgebers (7) für das vorgegebene Zeitintervall (32) vorzugeben, wobei die Steuereinrichtung (10) am Ende des vorgegebenen Zeitintervalls (32) an dem weiteren Steuerausgang (26) einen Steuerpuls (33) ausgibt.

4. Pulsgeber nach einem der vorangehenden Ansprüche, **dadurch gekennzeichnet, dass** der erste Puls (34) wenigstens um den Faktor zwei oder wenigstens um den Faktor fünf länger ist als der zweite Puls (36) oder die zweiten Pulse (36) und/oder dass der Abstand zwischen aufeinanderfolgenden Pulsen (34, 36) wenigstens zehnmal oder wenigstens dreißigmal so groß ist wie die Pulslänge.

5. Pulsgeber nach einem der vorangehenden Ansprüche, **dadurch gekennzeichnet, dass** die Kapazität (15) ausschließlich oder zumindest teilweise durch eine Gatterkapazität des Feldeffekttransistors (14) gebildet wird.

6. Pulsgeber nach einem der vorangehenden Ansprüche, **dadurch gekennzeichnet, dass** die Kapazität (15) zumindest teilweise durch eine Kapazität (15), insbesondere einen Kondensator, gebildet wird, die zwischen zwei Anschlüsse des Feldeffekttransistors (14) geschaltet ist.

7. Pulsgeber nach einem der vorangehenden Ansprüche, **dadurch gekennzeichnet, dass** der Feldeffekttransistor (14) ein Metall-Oxid-Halbleiter-Feldeffekttransistor ist.

8. Verbrauchszähler zur Erfassung eines Energieverbrauchs und/oder des Verbrauchs eines Fluids, **dadurch gekennzeichnet, dass** er einen Pulsgeber (7) nach einem der vorangehenden Ansprüche umfasst, insbesondere um Messdaten oder aus diesen abgeleitete Daten an eine separate Einrichtung (8) bereitzustellen.

## Claims

1. Pulse generator having a galvanically isolated output (17), in particular for a consumption meter (1), wherein a control output (9) of a control unit (10) of the pulse generator (7) is coupled to an input (11) of an opto-isolator (12) of the pulse generator (7) in order to output at the output (13) of the opto-isolator (12) an output current controlled by the control unit (10), wherein the opto-isolator (12) is connected to a field-effect transistor (14) in such a way that the output current from the opto-isolator (12) charges a capacitance (15) via a rectifying component (16), which blocks the capacitance (15) from discharging via the opto-isolator (12), wherein the voltage drop across the capacitance (15) is the gate voltage of the field-effect transistor (14), wherein the field-effect transistor (14) switches the output (17) of the pulse generator (7) directly or indirectly, **characterized in that** the pulse generator is configured to set a switching state of the output (17) of the pulse generator (7) for a predetermined time interval (32) by the control unit (10) outputting at the control output (9) a plurality of pulses (34, 36) during the predetermined time interval, wherein the control unit (10) is designed to output at the control output (9), at the start of the predetermined time interval (32), a first pulse (34) having a first length (35), and then during the time interval (32) at least a second pulse (36) having a second length (37), which is shorter than the first length (35).

2. Pulse generator according to Claim 1, **characterized in that** the terminals (21, 22) of the capacitance (15) are connected to output-side connecting terminals (23, 24) of an additional opto-isolator (25) of the pulse generator (7), wherein an input of the additional opto-isolator (25) is coupled to an additional control output (26) of the control unit (10).

3. Pulse generator according to Claim 2, **characterized in that** it is configured to set the switching state of the output (17) of the pulse generator (7) for the predetermined time interval (32), wherein the control unit (10) outputs a control pulse (33) at the additional control output (26) at the end of the predetermined time interval (32).

4. Pulse generator according to one of the preceding claims, **characterized in that** the first pulse (34) is longer than the second pulse (36) or the second pulses (36) at least by a factor of two or at least by a factor of five, and/or **in that** the interval between successive pulses (34, 36) is at least ten times, or at least thirty times, as large as the pulse length.

5. Pulse generator according to one of the preceding claims, **characterized in that** the capacitance (15) is formed exclusively or at least in part by a gate capacitance of the field-effect transistor (14).

6. Pulse generator according to one of the preceding claims, **characterized in that** the capacitance (15) is formed at least in part by a capacitance (15), in particular a capacitor, that is connected between two connecting terminals of the field-effect transistor (14).

7. Pulse generator according to one of the preceding claims, **characterized in that** the field-effect transistor (14) is a metal-oxide-semiconductor field-effect transistor.

8. Consumption meter for recording an energy consumption and/or the consumption of a fluid, **characterized in that** it comprises a pulse generator (7) according to one of the preceding claims, in particular in order to provide measurement data, or data derived from this measurement data, to a separate device (8).

## Revendications

1. Transmetteur d'impulsions comprenant une sortie (17) isolée galvaniquement, notamment pour un compteur de consommation (1), une sortie de commande (9) d'un dispositif de commande (10) du transmetteur d'impulsions (7) étant couplée à une entrée (11) d'un optocoupleur (12) du transmetteur d'impulsions (7) afin de délivrer, à la sortie (13) de l'optocoupleur (12), un courant de sortie commandé par le dispositif de commande (10), l'optocoupleur (12) étant connecté à un transistor à effet de champ (14) de telle sorte que le courant de sortie de l'optocoupleur (12) charge une capacité (15) par le biais d'un composant redresseur (16), qui bloque une décharge du condensateur (15) par le biais de l'optocoupleur (12), la tension qui chute aux bornes de la capacité (15) étant la tension de grille du transistor à effet de champ (14), le transistor à effet de champ (14) commutant la sortie (17) du transmetteur d'impulsions (7) directement ou indirectement, **caractérisé en ce que** le transmetteur d'impulsions est conçu pour prédéfinir un état de commutation de la sortie (17) du transmetteur d'impulsions (7) pendant un intervalle de temps (32) prédéfini, par le fait que le dispositif de commande (10) délivre plusieurs impulsions (34, 36) à la sortie de commande (9) pendant l'intervalle de temps prédéfini, le dispositif de commande (10) étant configuré pour délivrer, à la sortie de commande (9) au début de l'intervalle de temps (32) prédéfini, une première impulsion (34) ayant une première longueur (35) et ensuite, pendant l'intervalle de temps (32), au moins une deuxième impulsion (36) ayant une deuxième longueur (37) qui est plus courte que la première longueur (35).

2. Transmetteur d'impulsions selon la revendication 1, **caractérisé en ce que** les pôles (21, 22) de la capacité (15) sont reliés à des bornes côté sortie (23, 24) d'un optocoupleur supplémentaire (25) du transmetteur d'impulsions (7), une entrée de l'optocoupleur supplémentaire (25) étant couplée à une sortie de commande supplémentaire (26) du dispositif de commande (10) .

3. Transmetteur d'impulsions selon la revendication 2, **caractérisé en ce qu'**il est conçu pour prédéfinir l'état de commutation de la sortie (17) du transmetteur d'impulsions (7) pendant l'intervalle de temps (32) prédéfini, le dispositif de commande (10) délivrant une impulsion de commande (33) à la sortie de commande supplémentaire (26) à la fin de l'intervalle de temps (32) prédéfini.

4. Transmetteur d'impulsions selon l'une des revendications précédentes, **caractérisé en ce que** la première impulsion (34) est plus longue que la deuxième impulsion (36) ou les deuxièmes impulsions (36) au moins du facteur deux ou au moins du facteur cinq et/ou **en ce que** l'écart entre les impulsions successives (34, 36) est au moins dix fois ou au moins trente fois plus grand que la longueur d'impulsion.

5. Transmetteur d'impulsions selon l'une des revendications précédentes, **caractérisé en ce que** la capacité (15) est formée exclusivement ou au moins partiellement par une capacité de grille du transistor à effet de champ (14).

6. Transmetteur d'impulsions selon l'une des revendications précédentes, **caractérisé en ce que** la capacité (15) est formée au moins partiellement par une capacité (15), notamment un condensateur, qui est branché entre deux bornes du transistor à effet de champ (14).

7. Transmetteur d'impulsions selon l'une des revendications précédentes, **caractérisé en ce que** le transistor à effet de champ (14) est un transistor à effet de champ semiconducteur à grille métal-oxyde.

8. Compteur de consommation destiné à acquérir une consommation d'énergie et/ou la consommation d'un fluide, **caractérisé en ce qu'**il comporte un transmetteur d'impulsions (7) selon l'une des revendications précédentes, notamment pour fournir des données de mesure ou des données dérivées de celles-ci à un dispositif séparé (8).
